# EUROPEAN PATENT APPLICATION

(11) **EP 2 323 163 A2**
(43) Date of publication of application: **18.05.2011**
(21) Application number: 10001347.3
(22) Date of filing: 10.02.2010
(51) Int. Cl.: H01L 23/467, F28F 3/02

(54) **Cooling module**

(30) Priority: 13.11.2009 TW 98138641
(71) Applicant: Sunonwealth Electric Machine Industry Co., Ltd., Kaohsiung, Taiwan R.O.C. (TW)
(72) Inventor: Horng, Alex, Lingya District Kaohsiung (TW); Fang, I-Le, Lingya District Kaohsiung (TW)
(74) Representative: LOUIS, PÖHLAU, LOHRENTZ

(57) **Abstract**

A cooling module is presented, which includes a heat sink (1) and a fan unit (2). The heat sink (1) provides a base plate (11) and a plurality of fins (12), with an outlet (113) extending through the base plate (11) and the fins(2) formed on a first surface (111) of the base plate (11), and with a second surface (112) of the base plate (11) attached to a heat generating unit. The fan unit (2) is rotatably mounted on the heat sink (1) and aligned with the outlet (113). With the above-mentioned structure, an air-guiding channel (13) is formed between any adjacent two of the fins (12) and communicates with the outlet (113) for a part of air outputted by the fan unit (2) to be guided through the air-guiding channels (13) and exhausted by the outlet (113). Consequently, disturbed flows and wind noise are decreased while cooling efficiency is improved.

## Description

### BACKGROUND OF THE INVENTION

### 1. Field of the Invention

The present invention relates to a cooling module, particularly to a cooling module with reduced disturbed flow and low noise during operation.

### 2. Description of the Related Art

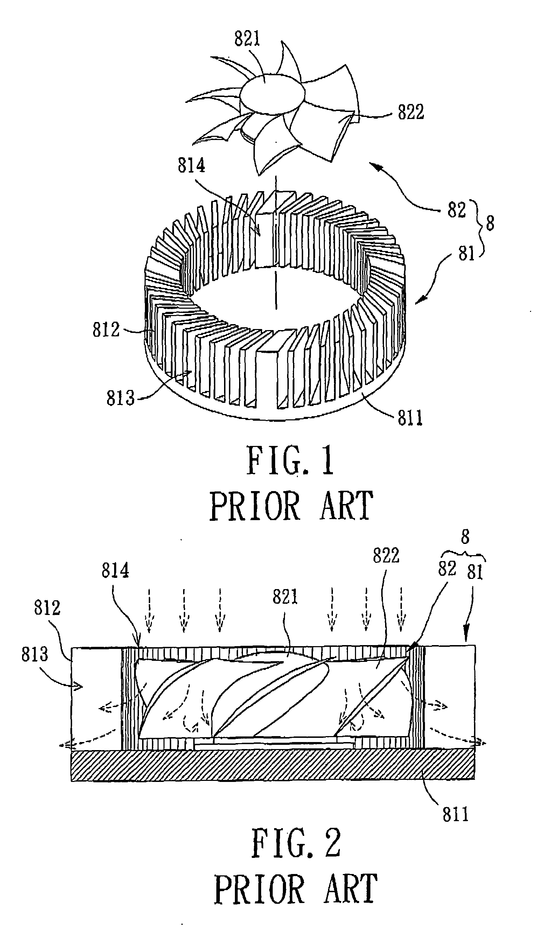

Referring to Figs. 1 and 2, a conventional cooling module 8 including a heat sink 81 and an axial fan 82 is shown. The heat sink 81 has a base plate 811, a plurality of fins 812 and a plurality of air-guiding channels 813. The base plate 811 is preferably in a round shape, with the fins 812 evenly arranged along a rim of an upper surface of the base plate 811, radially extending, and defining a compartment 814 on the upper surface. Each air-guiding channel 813 is disposed between any two adjacent fins 812 and communicates with the compartment 814. The axial fan 82 is received in the compartment 814 and has a hub 821 and a plurality of blades 822 arranged around a lateral wall of the hub 821.

In application of cooling electrical devices, a heat-generating unit, such as a central processing unit, a chip set, or a light-emitting diode, is attached to a bottom surface of the base plate 811 of the conventional cooling module 8. Heat generated by the heat-generating unit is absorbed by the bottom surface of the heat sink 81 and transmitted to the upper surface of the base plate 811 and the fins 812 in order to proceed a heat exchange process between the heat sink 81 and air around. Besides, the axial fan 82 axially drives an air flow towards the base plate 811 to refresh the air inside or around the heat sink 81 so as to facilitate said heat exchange process. Additionally, the heat air undergoing said heat exchange process is finally exhausted out of the cooling module 8 through an outer opening of the air-guiding channels 813.

In order to improve the cooling efficiency, the axial fan 82 preferably drives the air flow in a direction straight towards the base plate 811 of the heat sink 81. However, because the base plate 811 completely covers an outlet area of the axial fan 82 and the heat air can only be exhausted through the outer opening of the guiding air-channels 813, the disturbed flows are easily caused in a position adjacent to a section of each blade 822 where the blade 822 connects with the hub 821, as shown in Fig. 2. Accordingly, drawbacks such as low cooling efficiency and loud noise are resulted.

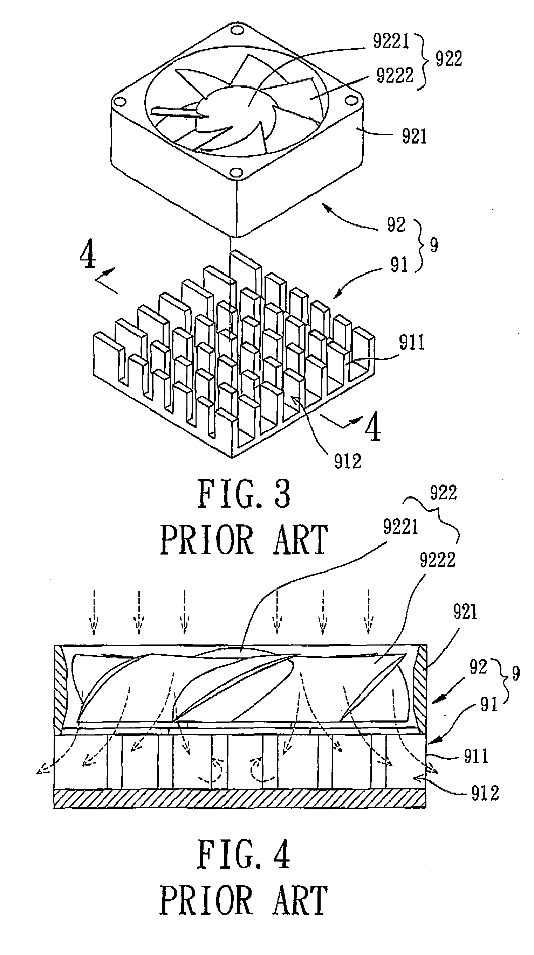

Please further refer to Figs. 3 and 4, wherein another conventional cooling module 9 including a heat sink 91 and an axial fan 92 is shown. A top surface of the heat sink 91 forms a plurality of fins 911 and a plurality of air-guiding channels 912. The fins 911 are arranged in a matrix-like form while each of the air-guiding channels 912 separates two adjacent fins 911. Besides, top edges of the fins 911 amount to forming a coupling portion for the axial fan 92 to be settled therein. The axial fan 92 includes a housing 921 and a fan wheel 922 rotatably mounted inside the housing 921 and has a hub 922 and a plurality of blades 9222 evenly arranged along a lateral wall of the hub 9221.

In application, a bottom surface of the heat sink 91 connects a heat-generating unit to directly absorb heat generated thereby, and the axial fan 92 continuously drives air toward the heat sink 91 to achieve a cooling purpose and to further ensure the proper operation temperature of the heat-generating unit.

However, the conventional cooling module 9 still has the drawbacks of the previously mentioned cooling module 8. In detail, when air is driven by the axial fan 92 into the air-guiding channels 912 of the heat sink 91, the air is easily separated into two parts with opposite flow directions, and this may result in disturbed flows at a position adjacent to the hub 9221 as shown in Fig. 4. Besides, due to the arrangement of the straight air-guiding channels 912, wind noise caused by the air guided through the fins 911 is also easily generated during the operation of the cooling module 9. Hence, there is a need to improve the conventional cooling modules 8, 9.

### SUMMARY OF THE INVENTION

It is the primary objective of this invention to provide a cooling module that reduces a disturbed flow generated between a fan unit and a heat sink.

It is the secondary objective of this invention to provide a cooling module with a reduced wind noise during operation.

It is another objective of this invention to provide a cooling module that facilitates the air flow and improves the cooling efficiency.

The cooling module in accordance with an aspect of the present invention comprises a heat sink and a fan unit. The heat sink has a base plate and a plurality of fins, wherein the base plate has a first surface, a second surface and an outlet extending from the first surface to the second surface, and the fins are arranged on the first surface of the base plate. The fan unit is mounted on the fins, aligned with the outlet, and has a fan wheel with a hub and a plurality of blades. A bottom edge of each of the fins connecting with the first surface extends along the first surface with a curve-pattern while an air-guiding channel is formed between any adjacent two of the fins, extends in a curved manner, and communicates with the outlet of the base plate.

The cooling module in accordance with another aspect of the present invention comprises a heat sink and a fan unit. The heat sink has a base plate and a plurality of fins, wherein an outlet and an auxiliary outlet section extend through the base plate, the outlet separates the base plate into a core portion on a center of the base plate and an outer portion and is sandwiched between the core and outer portions, the auxiliary outlet section is formed on an outer periphery of the outer portion, and the fins are arranged on a surface of the base plate and connect with the core and outer portions. The fan unit is mounted on the fins, aligned with the core portion of the base plate, and has a fan wheel with a hub and a plurality of blades. An air-guiding channel is formed between any adjacent two of the fins and communicates with the outlet and the auxiliary outlet section by two ends thereof.

Further scope of the applicability of the present invention will become apparent from the detailed description given hereinafter. However, it should be understood that the detailed description and specific examples, while indicating preferable embodiments of the invention, are given by way of illustration only, since various will become apparent to those skilled in the art from this detailed description.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein:
FIG 1 is an exploded perspective view of a conventional cooling module;
FIG 2 is a sectional side view of the conventional cooling module;
FIG 3 is an exploded perspective view of another conventional cooling module;
FIG 4 is a sectional side view of said another conventional cooling module;
Fig. 5 is an exploded perspective view of a cooling module in accordance with a first embodiment of the present invention;
FIG 6 is a top view of a heat sink and a plurality of blades in accordance with the first embodiment of the present invention;
FIG 7 is a cross sectional view of the cooling module of Fig. 6 according to section line 7-7 of Fig. 6;
Fig. 8 is an exploded perspective view of a cooling module in accordance with a second embodiment of the present invention;
FIG 9 is a top view of a heat sink and a plurality of blades in accordance with the second embodiment of the present invention;
FIG 10 is a cross sectional view of the cooling module of Fig. 9 according to section line 10-10 of Fig. 9;
Fig. 11 is an exploded perspective view of a cooling module in accordance with a third embodiment of the present invention;
FIG 12 is a top view of a heat sink and a plurality of blades in accordance with the third embodiment of the present invention; and
FIG. 13 is a cross sectional view of the cooling module of Fig. 12 according to section line 13-13 of Fig. 12.

In the various figures of the drawings, the same numerals designate the same or similar parts. Furthermore, when the term "first," "second," "third," "top," "bottom," "inner," "outer," and similar terms are used hereinafter, it should be understood that these terms are reference only to the structure shown in the drawings as it would appear to a person viewing the drawings and are utilized only to facilitate describing the invention.

### DETAILED DESCRIPTION OF THE INVENTION

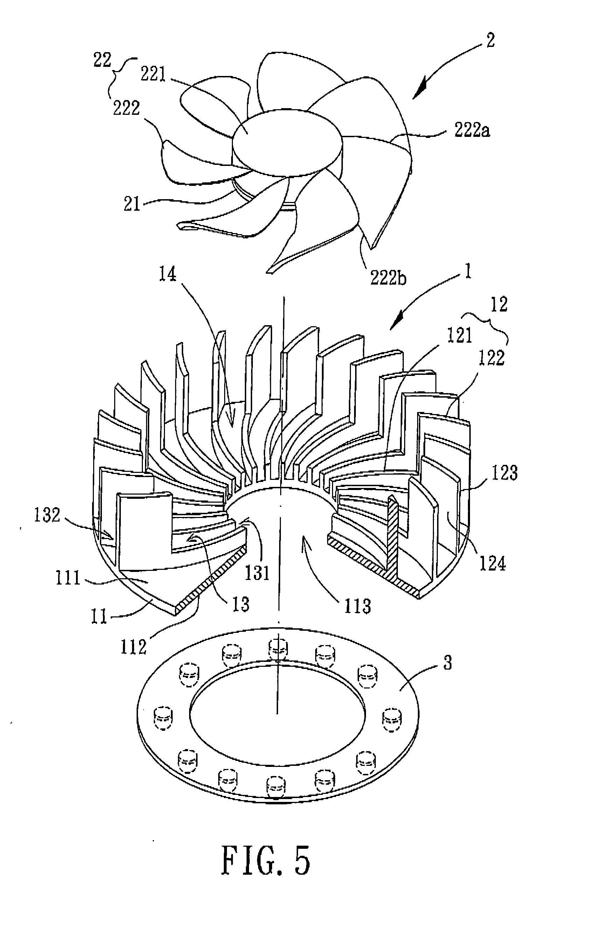

Referring to Fig. 5, a cooling module of a first embodiment of the present invention is shown. The cooling module includes a heat sink 1 and a fan unit 2 and is used to lower the temperature of a heat-generating unit of an electronic product. The heat sink 1 is made of a material with high thermal conductivity, such as aluminum, copper, or magnesium-aluminum ally. The fan unit 2 is mounted on a side of the heat sink 1, and another side of the heat sink 1 connects with the heat generating unit indicative of the numeral "3," with the heat generating unit 3 being a LED light in this embodiment. However, the heat generating unit 3 is not limited to the LED light; that is, a central processing unit or a chip set is also applicable.

The heat sink 1 has a base plate 11, a plurality of fins 12, and a plurality of air-guiding channels 13. The base plate 11 has a first surface 111 and a second surface 112 oppositely arranged at two sides of the base plate 11. Besides, the base plate 11 is preferably in the form of a round plate, but a plate in other shape such as rectangle, triangle, or any other polygon is also applicable. An outlet 113 is formed on a center of the base plate 11 and extends from the first surface 111 to the second surface 112. The fins 12, which radially extend relative to the center of the base plate 11 from the outlet 113 to an outer periphery of the base plate 11, are arranged on the first surface 111 of the base plate 11. Each of the fins 12 has a narrow section 121 and a wide section 122 aligned with the narrow section 121. The narrow section 121 and the wide section 122 are arranged from an edge of the outlet 113 to said outer periphery of the base plate 11 in order. Specifically, an end of the narrow section 121, which is away from the wide section 122, is adjacent to the outlet 113, and an end of the wide section 122, which is away from the narrow section 121, is adjacent to the outer periphery of the base plate 11. Specifically, a height between a top edge of the narrow section 121 and the first surface 111 is smaller than that between a top edge of the wide section 122 and the first surface 111, wherein the top edges thereof are edges of any one of the fins 12 opposite to a bottom edge of the fin 12 connecting with the first surface 111, and a lateral edge of the wide section 122 is formed between and links the top edges of the narrow and wide sections 121, 122 of each fm 12. With the above structure, a recess 14 is defined by the top edges of the narrow sections 121 and lateral edges of the wide sections 122 and communicates with the outlet 113 of the base plate 11.

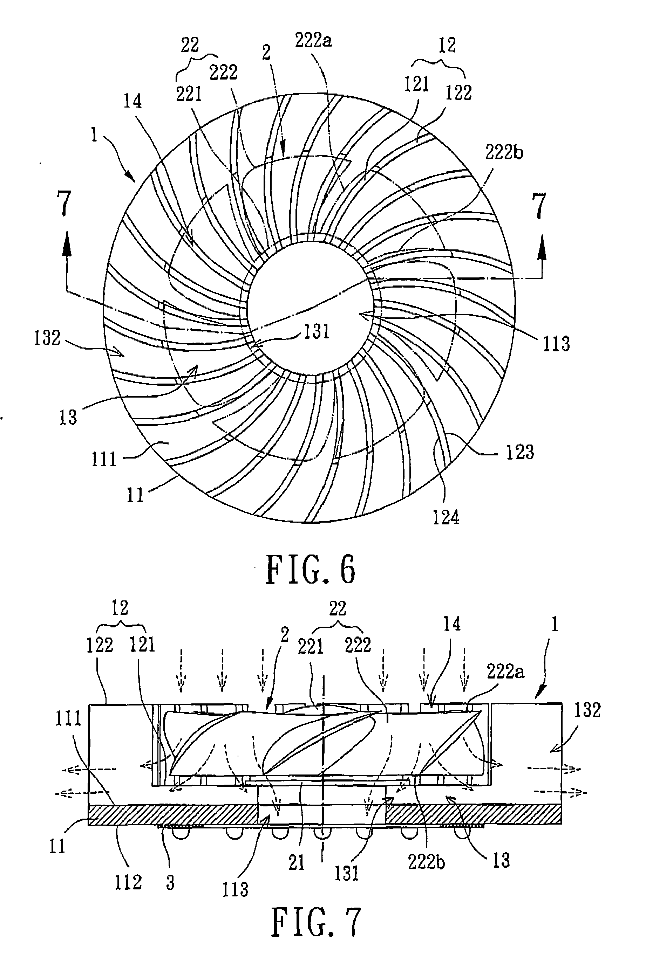

Now referring to Figs. 5 and 6, the bottom edges of the radially extending fins 12 have an identical curve-pattern. Specifically, with said curve-pattern, each fin 12 has a convex surface 123 and a concave surface 124 forming two opposite sides thereof, with the convex surface 123 of any one of the fins 12 facing the concave surface 124 of an adjacent one of the fins 12. In detail, extending directions of the curve-patterns of the bottom edges are designed as corresponding to a rotational direction of the fan unit 2. In this embodiment, the convex surface 123 faces in a direction identical to the rotational direction of the fan unit 2 at this convex surface 123. Please still refer to Figs. 5 and 6, each air-guiding channels 13 sandwiched between any two adjacent fins 12 would appear to be expended in a curved manner due to the curve-patterned fins 12. Besides, each air-guiding channel 13 has an inner opening 131 and an outer opening 132 respectively at two radial ends thereof, with the inner opening 131 connecting with the outlet 113.

The fan unit 2 is received in the recess 14 of the heat sink 1 and supported by and positioned on the top edges of the narrow sections 121, so that the fan unit 2 is aligned with the outlet 113. The fan unit 2 is preferably an axial fan and includes a base 21 and a fan wheel 22 that is rotatably mounted on the base 21. The fan wheel 22 has a hub 221 and a plurality of blades 222 arranged along a lateral wall of the hub 221 while the air-guiding channels 13 between the narrow sections 121 are disposed between the base plate 11 and the blades 222 in an axial direction of the fan unit 2. Each of the blades 222 includes an air input side 222a and an air output side 222b respectively at the top and the bottom thereof.

Referring to Figs. 5 through 7, during the operation, the heat sink 1 continuously absorbs heat generated by the heat generating unit 3. Besides, through an operation of the fan unit 2, cool air enters the fan unit 2 from the air input side 222a and is driven to the air-guiding channels 13 through the air output side 222b in order to proceed a heat exchange process between the base plate 11 and fins 12, thereby lowering the temperature of the heat sink 1 as well as the heat generating unit 3. When the fan wheel 22 of the fan unit 2 rotates, a rotation range of the rotating blades 222 may axially project a donut-like range onto a plane, whereon the base plate 11 is disposed, to define a ring projection range. The ring projection range herein may be smaller than and totally covered by the base plate 11. Besides, the outlet 113 is outside of the ring projection range and is arranged in a position where all air-guiding channels 13 converge. Preferably, the hub 221 may also axially project a disk-like range onto said plane to define a round projection range, with the round projection range of the hub 221 completely located within the range of the outlet 113. Based on the structure, when the above fan unit 2 outputs the cool air straight downwards, the base plate 11 blocks the air flow of the cool air. As the air flow of the cool air is directly driven towards the first surface 111 of the base plate 11, the base plate 11 splits the air flow into an inward air flow towards the inner openings 131 and an outward air flow towards the outer openings 132. Accordingly, the heat exchange process between the cool air and the heat sink 1 may involve wider areas, and the time period of the heat exchange process is also prolonged, thus improving the cooling efficiency.

Furthermore, the inward air flow guided by the air-guiding channels 13 and absorbing heat of the heat sink 1 finally reaches the outlet 113 and is exhausted from the cooling module through the outlet 113, and thus avoiding disturbed flow near the hub 221 of the fan wheel 22. On the other hand, the outward air flow also guided by the air-guiding channels 13 and absorbing heat of the heat sink 1 is exhausted by the outer openings 132. Accordingly, the ventilation of air flow is facilitated and heat dissipation efficiency is improved. As a result, a preferable working temperature is maintained for long-term operation of the heat generating unit 3, achieving purposes such as high operation efficiency and longer lifetime of the heat generating unit 3.

Besides, with the design of the curved fins 12 and air-guiding channels 13 according to the rotational direction of the fan wheel 22, the cool air can be smoothly guided inside the air-guiding channels 13 to undergo the heat exchange process without loud wind noise and disturbed flow.

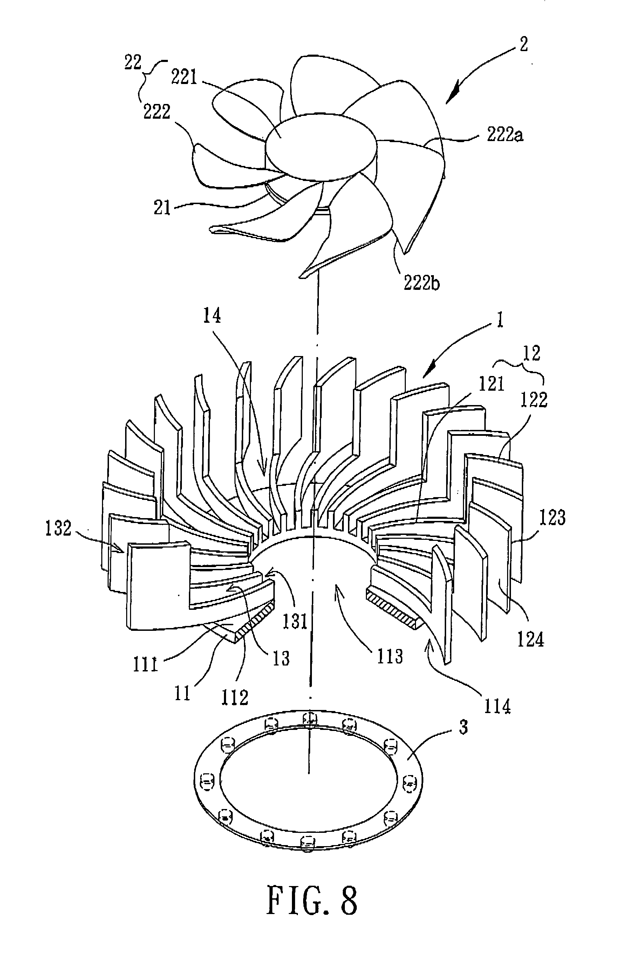

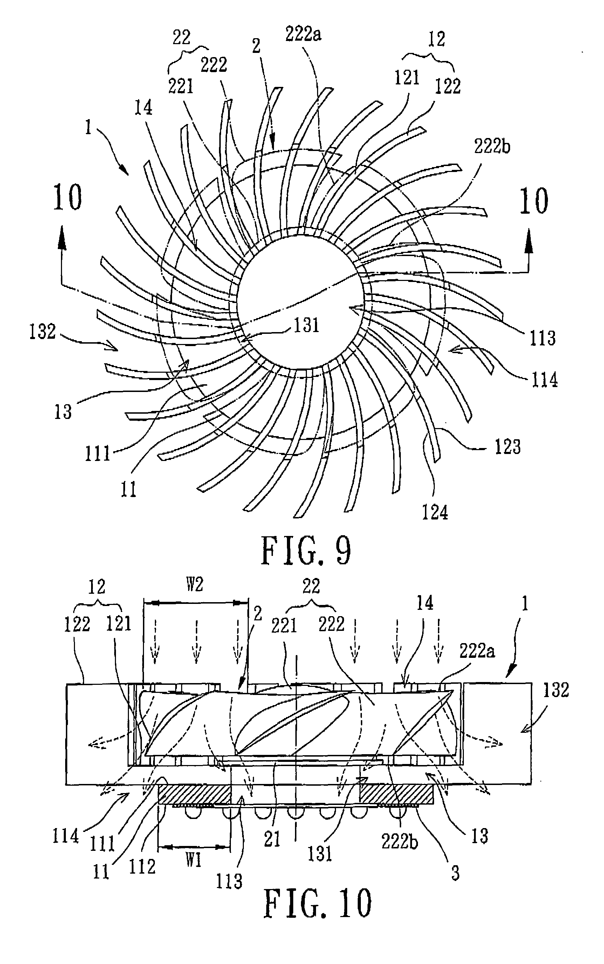

Referring to Figs. 8 through 10 now, a cooling module of a second embodiment of the present invention is shown. In comparison with the first embodiment, what is different is that, except for the outlet 113 disposed on the center of the base plate 11, an auxiliary outlet section 114 is annularly formed along the outer periphery of the base plate 11 and is adjacent to the outer openings 132. Similar to the outlet 113, the auxiliary outlet section 114 also extends from first surface 111 to the second surface 112 of the base plate 11 and communicates with the air-guiding channels 13. Moreover, a radial width W1 of the base plate 11 between the outlet 113 and the auxiliary outlet section 114 is smaller than a radial length W2 of each blade 222, and the base plate 11 is totally located within the range of the previously mentioned ring projection range as shown in Fig. 10.

Accordingly, with the above-illustrated design of the base plate 11 of this second embodiment, the cool air entering the fan unit 2 can still straightly send to and contact with the base plate 11 for the heat exchange process. Moreover, areas of interfaces between the air-guiding channels 13 and the outside of the cooling module can be further increased for the inward and outward air flows to be exhausted fast.

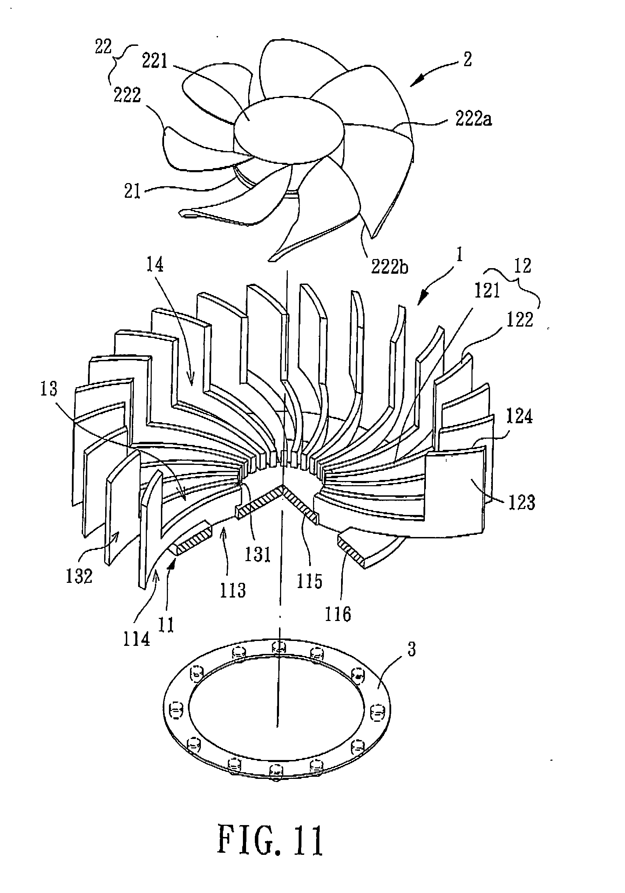

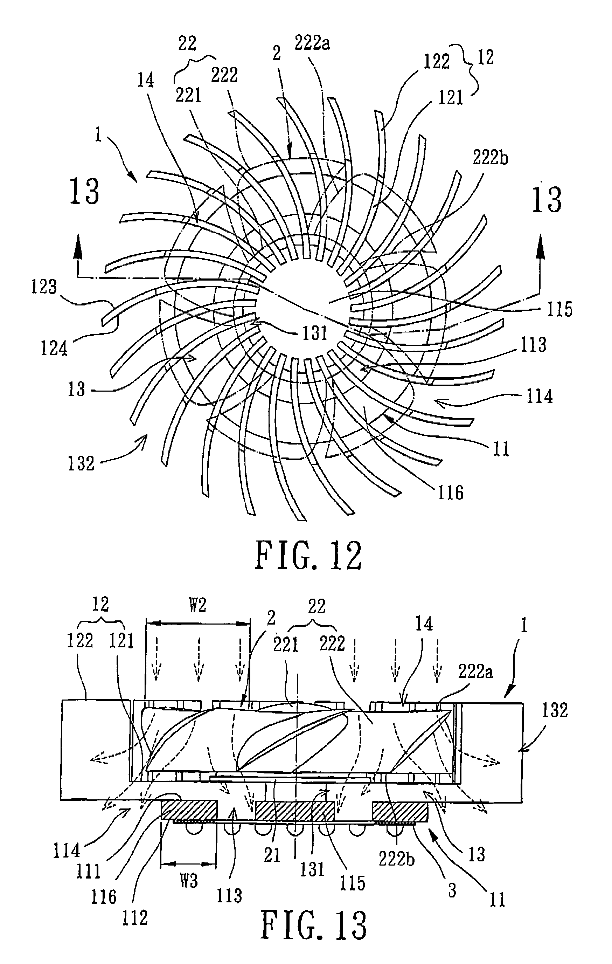

Now turning to Figs. 11 through 13, a cooling module of a third embodiment of the present invention is shown. In comparison with the base plate 11 of the second embodiment, the outlet 113 of the base plate 11 in the present embodiment is formed in a ring shape to separate the base plate 11 into a core portion 115 and an outer portion 116. The core portion 115 is arranged on the center of the base plate 11 and axially aligned with the hub 221 of the fan wheel 22. The outer portion 116 is radially sandwiched between the outlet 113 and the auxiliary outlet section 114, while the outlet 113 is sandwiched between the core portion 115 and the outer portion 116. Relative positions of the core portion 115 and outer portion 116 are fizzed through the narrow sections 121 of the fins 12, with the outlet 113 communicating with the air-guiding channel 13. At least one of two parts of the second surface 112, which are respectively located on the . core portion 115 and outer portion 116, couples the heat generating unit 3 for at least one of the core and outer portions 115, x 16 to absorb heat generated thereby and transmit the heat to the fins 12. Besides, a radial width W3 of the outer portion 116 between the outlet 113 and the auxiliary outlet section 114 is smaller than the radial length W2 of each blade 222, and the outer portion 116 is totally located within the range of the previously mentioned ring projection range as shown in Fig. 13.

With the core portion 115 of this third embodiment, a circular edge of the core portion 115 defining a side of the outlet 113 perfectly aligns with the lateral wall of the hub 221 when the fan wheel 22 is received in the recess 14. In addition, the outer portion 116 in this embodiment serves like the whole base plate 11 in the second embodiment to block the straight way of the air flow outputted by the fan unit 2 and to increase areas of interfaces between the air-guiding channels 13 and the outside of the cooling module for the inward and outward air flows to be exhausted fast. Moreover, in reference to the Fig. 12, the convex surface 123 can also face in a direction opposite to the rotational direction of the fan wheel 22 at this convex surface 123 to increase the time for the heat exchange process.

Although the invention has been described in detail with reference to its presently preferred embodiment, it will be understood by one of ordinary skill in the art that various modifications can be made without departing from the spirit and the scope of the invention, as set forth in the appended claims,

## Claims

1. A cooling module, comprising:
a heat sink (1) having a base plate (11) and a plurality of fins (12), wherein the base plate (11) has a first surface (111), a second surface (112) and an outlet (113) extending from the first surface (111) to the second surface (112), and the fins (12) are arranged on the first surface (111) of the base plate (11); and
a fan unit (2) mounted on the fins (12), aligned with the outlet (113), and having a fan wheel (22) with a hub (221) and a plurality of blades (222),
wherein a bottom edge of each of the fins (12) connecting with the first surface (111) extends along the first surface (111) with a curve-pattern while an air-guiding channel (13) is formed between any adjacent two of the fins (12), extends in a curved manner, and communicates with the outlet (113) of the base plate (11).

2. The cooling module as defined in claim 1, wherein the outlet (113) is formed on a center of the base plate (11) and the fins (12) are arranged on the first surface (111) and radially extend relative to the outlet (113).

3. The cooling module as defined in claim 1, wherein the fan unit (2) is mounted on top edges of the fins (12), with the top edges being opposite to the bottom edges of the fins (12), and a round projection range defined by projecting the hub (221) onto a plane whereon the base plate (11) is disposed is located within a range of the outlet (113).

4. The cooling module as defined in claim 1, wherein an auxiliary outlet section (114) is formed on an outer periphery of the base plate (11), while the base plate (11) is sandwiched between the outlet (113) and the auxiliary outlet section (114).

5. The cooling module as defined in claim 4, wherein a radial width of the base plate (11) between the outlet (113) and the auxiliary outlet section (114) is smaller than a radial length of each blade (222), and the base plate (11) is located within a ring projection range defined by projecting a rotation range of the blades (222) onto a plane whereon the base plate (11) is disposed.

6. The cooling module as defined in claim 1, wherein extending directions of the curve-patterns of the bottom edges are arranged corresponding to a rotational direction of the fan wheel (22) while the curve-patterns are identical, and each of the fins (12) has a convex surface (123) faces in a direction identical to the rotational direction of the fan wheel (22) at said convex surface (123).

7. The cooling module as defined in claim 1, wherein extending directions of the curve-patterns of the bottom edges are arranged corresponding to a rotational direction of the fan wheel (22) while the curve-patterns are identical, and each of the fins (12) has a convex surface (123) faces in a direction opposite to the rotational direction of the fan wheel (22) at said convex surface (123).

8. The cooling module as defined in claim 1, wherein each of the fins (12) has a narrow section (121) and a wide section (122) connecting with each other, and a height between a top edge of the narrow section (121) and the first surface (111) is smaller than another height between a top edge of the wide section (122) and the first surface (111).

9. A cooling module, comprising:
a heat sink (1) having a base plate (11) and a plurality of fins (12), wherein an outlet (113) and an auxiliary outlet section (114) extend through the base plate (11), the outlet (113) separates the base plate (11) into a core portion (115) on a center of the base plate (11) and an outer portion (116) and is sandwiched between the core portion (115) and the outer portion (116), the auxiliary outlet section (114) is formed on an outer periphery of the outer portion (116), and the fins (12) are arranged on a surface of the base plate (11) and connect with the core portion (115) and the outer portion (116); and
a fan unit (2) mounted on the fins (12), aligned with the core portion (115) of the base plate (11); and having a fan wheel (22) with a hub (221) and a plurality of blades (222),
wherein an air-guiding channel (13) is formed between any adjacent two of the fins (12) and communicates with the outlet (113) and the auxiliary outlet section (114) by two ends thereof.

10. The cooling module as defined in claim 9, wherein both of the outlet (113) and auxiliary outlet section (114) are in ring shapes, with the outlet (113) annularly formed along an outer periphery of the core portion (115) and the auxiliary outlet section (114) annularly formed along the outer periphery of the outer portion (116).

11. The cooling module as defined in claim 9, wherein a radial width of the outer portion (116) between the outlet (113) and the auxiliary outlet section (114) is smaller than a radial length of each blade (222), and the outer portion (116) is located within a ring projection range defined by projecting a rotation range of the blades (222) onto a plane whereon the base plate (11) is disposed.

12. The cooling module as defined in claim 9, wherein a bottom edge of each of the fins (12) connecting with the base plate (11) extends along the base plate (11) with a curve-pattern while the air-guiding channel (13) forme between any adjacent two of the fins (12) extends in a curved manner.

13. The cooling module as defined in claim 12, wherein extending directions of the curve-patterns of the bottom edges are arranged corresponding to a rotational direction of the fan wheel (22) while the curve-patterns are identical, and each of the fins (12) has a convex surface (123) faces in a direction identical to the rotational direction of the fan wheel (22) at said convex surface (123).

14. The cooling module as defined in claim 12, wherein extending directions of the curve-patterns of the bottom edges are arranged corresponding to a rotational direction of the fan wheel (22) while the curve-patterns are identical, and each of the fins (12) has a convex surface (I23) faces in a direction opposite to the rotational direction of the fan wheel (22) at said convex surface (123).

15. The cooling module as defined in claim 9, wherein each of the fins (12) has a narrow section (121) and a wide section (122) connecting with each other, and a height between a top edge of the narrow section (121) and the base plate (11) is smaller than another height between a top edge of the wide section (122) and the base plate (11).
